(19) Europäisches Patentamt
European Patent Office
Office européen des brevets

(11) **EP 4 275 918 A1**

(12) **EUROPEAN PATENT APPLICATION**
published in accordance with Art. 153(4) EPC

(43) Date of publication:
**15.11.2023 Bulletin 2023/46**

(21) Application number: **21926698.8**

(22) Date of filing: **14.10.2021**

(51) International Patent Classification (IPC):
**B60C 19/00** $^{(2006.01)}$    **B60C 15/02** $^{(2006.01)}$

(52) Cooperative Patent Classification (CPC):
**B60C 15/02; B60C 19/00**

(86) International application number:
**PCT/JP2021/038056**

(87) International publication number:
**WO 2022/176269 (25.08.2022 Gazette 2022/34)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **22.02.2021 JP 2021026482**

(71) Applicant: **Sumitomo Rubber Industries, Ltd.**
**Kobe-shi, Hyogo 651-0072 (JP)**

(72) Inventor: **AOKI, Chieko**
**Kobe-shi, Hyogo 651-0072 (JP)**

(74) Representative: **Manitz Finsterwald**
**Patent- und Rechtsanwaltspartnerschaft mbB**
**Martin-Greif-Strasse 1**
**80336 München (DE)**

(54) **BEAD CLAMPING FORCE PREDICTION METHOD, TIRE MANUFACTURING METHOD, AND TIRE**

(57)    It is a method for predicting a pressing force BF of a bead portion 4 of a tire 1 having a bead core 5 in the bead portion 4. It comprises a step of predicting the pressing force BF of the bead portion 4 when the tire 1 is fitted onto a rim R of a wheel by using a numeric expression. In the predicting step, the bead pressing force BF is predicted by using the inner diameter IDw of the bead core, the diameter ODR of the rim, and the thickness Ct inward in the tire radial direction from the bead core 5.

FIG.2

**Description**

Technical field

The present disclosure relates to a method for predicting a bead pressing force of a tire having a bead core in a bead portion, a tire manufacturing method using the method, and a tire.

Background art

If a pressing force of a bead portion of a tire is too large, the workability of mounting it on a rim may deteriorate, and if it is too small, problems such as tire/wheel slippage, bead unseating, and air leakage may occur.
For example, Patent document 1 below proposes a pneumatic tire in which, by optimizing the shape of the surface of the heel of the bead portion, the bead pressing force and the gradient thereof are reduced in variations.

Prior art documents

Patent document

Patent document 1: Japanese Patent Application Publication No. 2017-193194

Summary of the Invention

Problems to be solved by the Invention

However, as the pneumatic tire of Patent document 1 needs to measure the pressing force of the bead portion using a testing machine or to perform structural calculation by simulation, it has been desired to easily predict the bead pressing force from design parameters.
The present disclosure has been devised in view of the actual situation as described above, and a primary objective is to provide a method for accurately and easily predicting the pressing force of the bead portion from design parameters, a tire manufacturing method using the method, and a tire.

Means of solving the problems

The present disclosure is a bead pressing force prediction method which is a method for predicting a pressing force of a bead portion of a tire having a bead core in the bead portion, and which comprises a step of predicting a pressing force of the bead portion when the tire is fitted on a rim of a wheel, by using the following numeric expression (1):

[ Exp. 1 ]

$$BF = a1 \times \varepsilon c + a2$$

$$\varepsilon c = \left(1 - \frac{(IDw - ODR) \times 0.5)}{Ct}\right) \times 100 \qquad ...(1)$$

wherein

BF: the bead pressing force [N]
$\varepsilon c$: compressive strain on the inside in the radial direction of the tire of the bead core 5 [%]
IDw: the inner diameter of the bead core 5 [mm]
ODR: the diameter of the rim [mm]
Ct: a thickness inward in the radial direction of the tire from the bead core 5 [mm]
a1: a coefficient for obtaining the pressing force BF from the compressive strain $\varepsilon c$
a2: a constant

Effect of the Invention

The bead pressing force prediction method of the present disclosure is provided with the above configuration, and thereby, can accurately and easily predict the pressing force of the bead portion from the design parameters.

Brief description of the Drawing

[FIG. 1] A cross-sectional view of an embodiment of a tire of the present disclosure.
[FIG. 2] A schematic diagram showing a bead portion of the present embodiment.
[FIG. 3] A cross-sectional view showing a bead portion of another embodiment.
[FIG. 4] A cross-sectional view showing a bead portion of still another embodiment.

Mode for carrying out the Invention

Hereinafter, an embodiment of the present disclosure will be described in detail based on the drawings.

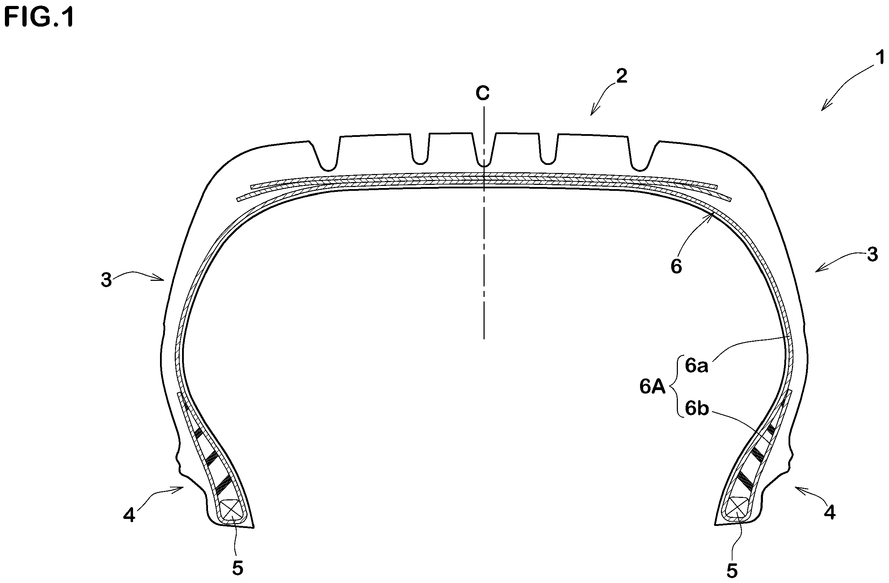

in FIG. 1, there is shown a tire meridian cross-sectional view of a tire 1 of the present embodiment including a rotational axis under its normal state.
The tire 1 of this embodiment is suitably used as a rubber pneumatic tire to be mounted on a passenger car or the like. Note that the tire 1 is not limited to a rubber pneumatic tire for passenger cars, and can be applied to various tires 1, e.g. heavy-duty pneumatic tires, resin pneumatic tires and the like.
when the tire 1 is a rubber pneumatic tire, the "normal state" is a no-load state in which the tire 1 is mounted on a normal rim R and adjusted to a normal internal pressure.
Hereinafter, dimensions and the like of each part of the tire 1 are values measured in this normal state unless otherwise noted.
The "normal rim R" is a rim specified for the respective tire in a standard system including standards on which the tire 1 is based, for example, "Standard Rim" in the case of JATMA, "Design Rim" in the case of TRA, and "Measuring Rim" in the case of ETRTO.
when there is no standard system including standards on which the tire 1 is to be based, the "normal rim R" is a rim specified for the respective tire by the manufacturer or the like.
The "normal internal pressure" is the air pressure specified for the respective tire in a standard system including standards on which the tire 1 is based, and it is "maximum air pressure" in the case of JATMA, it is the maximum value described in the table "TIRE LOAD LIMITS AT VARIOUS COLD INFLATION PRESSURES" in the case of TRA, and it is "INFLATION PRESSURE" in the case of ETRTO.
when there is no standard system including standards on which the tire 1 is to be based, the "normal internal pressure" is the air pressure specified for the respective tire by the manufacturer or the like.
As shown in FIG. 1, the tire 1 of the present embodiment comprises a tread portion 2 extending annularly including the tire equator C, a pair of sidewall portions 3 extending to both sides of the tread portion 2, and a pair of bead portions 4 extending in series from the sidewall portions 3.
The bead portion 4 of this embodiment is equipped with a bead core 5.
The tire 1 is equipped with, for example, a carcass 6 extending between the bead cores 5 of the pair of bead portions 4 in a toroidal shape.
The carcass 6 comprises at least one, in this embodiment, one carcass ply 6A.
The carcass ply 6A comprises, for example, carcass cords (not shown) arranged at an angle of 75 to 90 degrees with respect to the tire circumferential direction.
As the carcass cord, for example, organic fiber cord such as aromatic polyamide or rayon can be used.
The carcass ply 6A comprises, for example, a main body portion 6a extending between the paired bead cores 5, and folded-back portions 6b connected to the main body portion 6a and folded back around the bead cores 5 from the inner side to the outer side in the axial direction of the tire. Such carcass ply 6A has a portion located inside the bead core 5 in the radial direction of the tire.

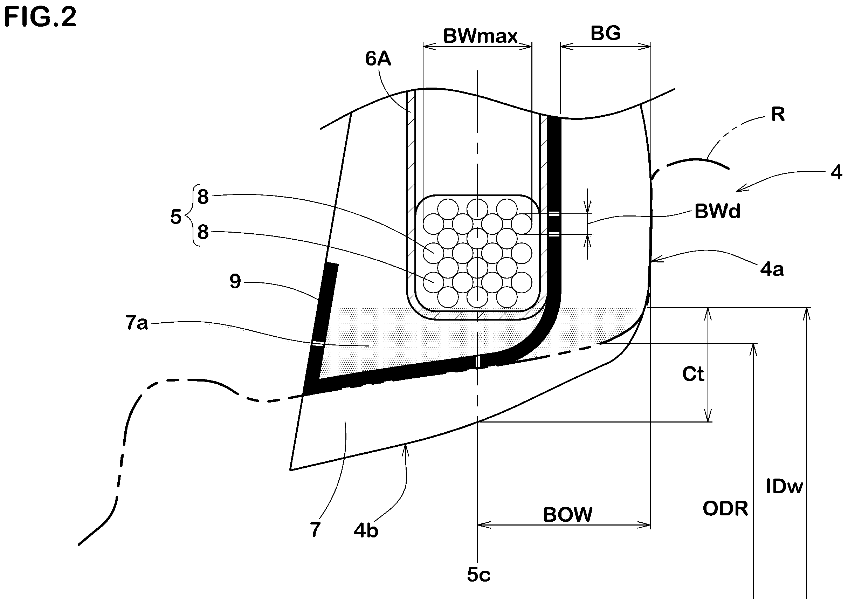

FIG. 2 is a schematic diagram showing the bead portion 4 of the present embodiment.
As shown in FIG. 2, when the tire 1 of the present embodiment is mounted on the rim R of a wheel, an outer surface 4a in the tire axial direction and an inner surface 4b in the tire radial direction of the bead portion 4 are in contact with the rim R of the wheel.
For example, when the tire 1 is mounted on the rim R of the wheel, a rubber member 7 radially inward of the bead core 5 is compressed to a rubber member 7a colored in FIG. 2. Therefore, when the tire 1 is mounted on the rim R of the wheel, a pressing force BF is generated in the bead portion 4.

Such pressing force BF of the bead portion 4 can suppress rim slippage, bead unseating and the like, and can suppress leakage of air through between the tire 1 and the rim R.

The bead pressing force prediction method of the present embodiment comprises a step of predicting the pressing force BF of the bead portion 4 when the tire 1 is fitted onto the rim R of the wheel using the following numeric expression (1):

[ Exp. 1 ]

$$BF = a1 \times \varepsilon c + a2$$

$$\varepsilon c = \left(1 - \frac{(IDw - ODR) \times 0.5)}{Ct}\right) \times 100 \qquad \qquad ...(1)$$

wherein

BF: the bead pressing force [N]
$\varepsilon c$: compressive strain on the inside in the tire radial direction of the bead core 5 [%]
IDw: the inner diameter of the bead core 5 [mm]
ODR: the diameter of the rim [mm]
Ct: a thickness inward in the tire radial direction from the bead core 5 [mm]
a1: a coefficient for obtaining the pressing force BF from the compressive strain $\varepsilon c$
a2: a constant

Such bead pressing force prediction method can predict the pressing force BF of the bead portion 4 from the inner diameter IDw of the bead core 5, the diameter ODR of the rim, and the thickness Ct inward in the tire radial direction from the bead core 5. Therefore, in the bead pressing force prediction method of the present embodiment, from these design parameters, the pressing force BF of the bead portion 4 can be accurately and easily predicted.

It is desirable that the coefficient a1 and the constant a2 are obtained experimentally by multivariate analysis or the like from values measured using a tire bead pressing force tester in advance.

The thickness Ct inward in the tire radial direction from the bead core 5 is, for example, the thickness Ct before the tire 1 is mounted on the rim R of the wheel, and the thickness Ct at the center 5c in the tire axial direction of the bead core 5 can be taken as the representative value.

The center 5c of the bead core 5 in the tire axial direction is, for example, the center 5c of the maximum width BWmax of the bead core 5 in the tire axial direction.

It is desirable that the maximum width BWmax of the bead core 5 is the width between the outer end surfaces on both sides in the tire axial direction of the bead wires 8 forming the bead core 5.

The shape of the bead core 5 is not limited to the shape shown in FIG. 2.

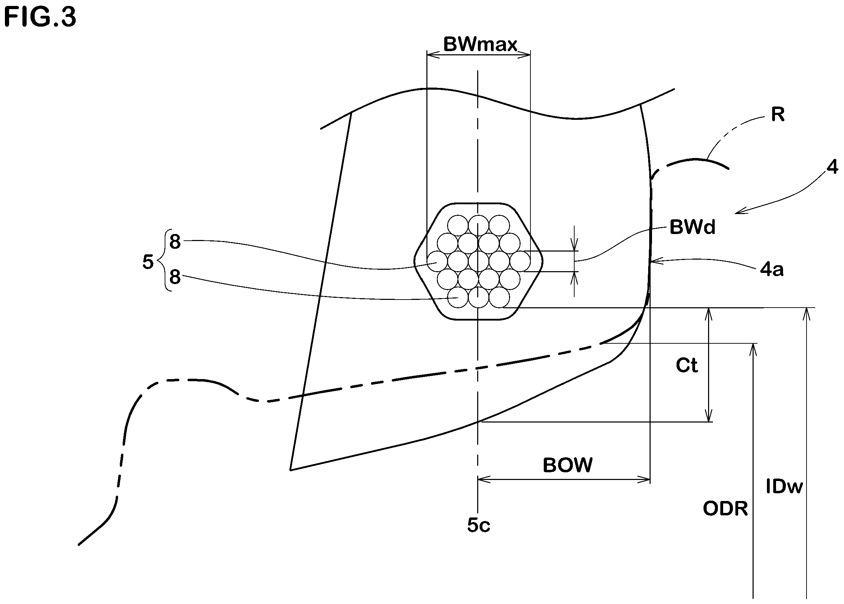

FIG. 3 is a schematic diagram showing the bead portion 4 of another embodiment, and

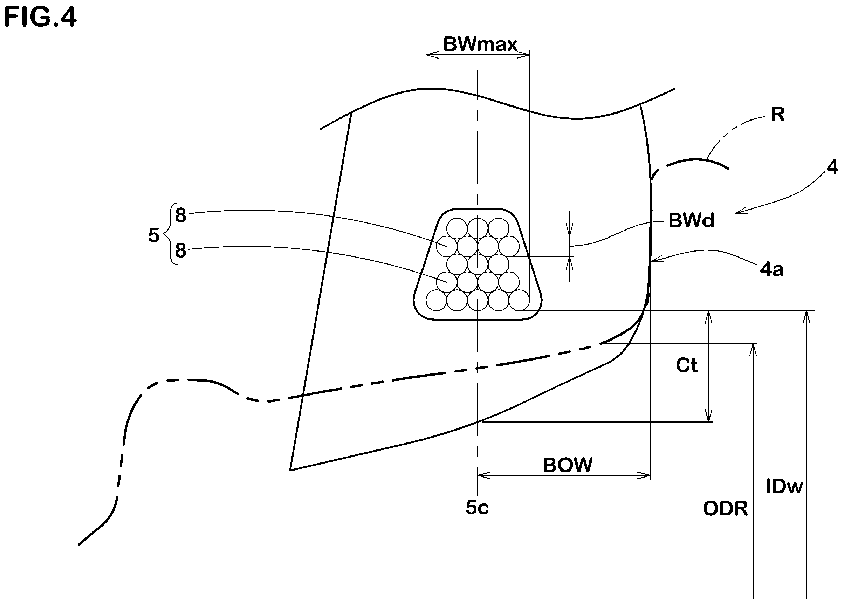

FIG. 4 is a schematic diagram showing the bead portion 4 of still another embodiment.

As shown in FIG. 3, the bead core 5 may have, for example, bead wires 8 arranged in a hexagonal shape.

The maximum width BWmax of the bead core 5 in this case is the width between the axially opposite outer end surfaces of the bead wires 8 positioned at the center in the radial direction of the tire.

As shown in FIG. 4, the bead core 5 may have, for example, bead wires 8 arranged in a trapezoidal shape.

In this case, the maximum width BWmax of the bead core 5 is the width between the axially opposite outer end surfaces of the bead wires 8 located radially inward of the tire.

Although FIG. 2 illustrates the carcass ply 6A and a chafer rubber 9 in a compressed state at the bead portion 4, the illustration thereof is omitted in FIGS. 3 and 4.

As shown in FIGS. 2 to 4, it is desirable that the bead pressing force prediction method predicts the pressing force BF of the bead portion 4 by using values from the allowable maximum value to minimum value of the diameter ODR of the rim.

Here, the allowable maximum and minimum values of the diameter ODR of the rim are "the diameter ODR of the rim +/- 0.4 mm" for JATMA, "the diameter ODR of the rim +/- 0.4 mm" for TRA, and "the rim circumferential length +/-1.2 mm" for ETRTO.

Such bead pressing force prediction method can always achieve both workability of mounting to the rim R and suppression of rim slippage, bead unseating, air leakage, etc. within the allowable range of the diameter ODR of the rim.

Next, a bead pressing force prediction method of a second embodiment will be described.

The bead portion 4 of the second embodiment is equipped with a bead core 5 made up of bead wires 8.

The bead pressing force prediction method of the second embodiment comprises a step of predicting the pressing force BF of the bead portion 4 when the tire 1 is mounted on the rim R of the wheel using the following numeric expression (2).

[ Exp. 2 ]

$$BF = a3 \times \varepsilon c + a4 \times BWST + a5$$

$$\varepsilon c = \left(1 - \frac{(IDw - ODR) \times 0.5}{Ct}\right) \times 100 \qquad ...(2)$$

$$BWST = BWd \times BWdn$$

wherein

BF: the bead pressing force [N]
$\varepsilon c$: compressive strain on the inside in the tire radial direction of the bead core 5 [%}
IDw: the inner diameter of the bead core 5 [mm]
ODR: the diameter of the rim [mm]
Ct: a thickness inward in the tire radial direction from the bead core 5 [mm]
BWST: a bead wire configuration
BWd: a wire diameter of the bead wire [mm]
BWdn: a number of the bead wires 8 arranged on the most inside in the tire radial direction [integer]
a3: a coefficient for obtaining the pressing force from the compressive strain
a4: a coefficient for obtaining the pressing force from the bead wire configuration
a5: a constant

Such bead pressing force prediction method can predict the pressing force BF of the bead portion 4 from the inner diameter IDw of the bead core 5, the diameter ODR of the rim, the thickness Ct inward in the tire radial direction from the bead core 5, the wire diameter BWd of the bead wires, and the number BWdn of the bead wires 8 arranged on the most inside in the tire radial direction.

Therefore, from these design parameters, the bead pressing force prediction method of the second embodiment can accurately and easily predict the pressing force BF of the bead portion 4.

It is desirable that the coefficient a3, the coefficient a4 and the constant a5 are obtained experimentally by multivariate analysis or the like from values measured using a tire bead pressing force tester in advance.

The number BWdn of the bead wires 8 arranged on the most inside in the tire radial direction is, for example, three in the examples of FIGS. 2 and 3, and five in the example of FIG. 4.

The bead pressing force prediction method of the second embodiment predicts the pressing force BF using the allowable maximum and minimum values of the diameter ODR of the rim, like in the bead pressing force prediction method described above. Such bead pressing force prediction method can always achieve both workability of mounting to the rim R and suppression of rim slippage, bead unseating, air leakage, etc. within the allowable range of the diameter ODR of the rim.

Next, a bead pressing force prediction method of a third embodiment will be described. The bead pressing force prediction method of the third embodiment comprises a step of predicting the pressing force BF of the bead portion 4 when the tire 1 is fitted onto the rim R of a wheel using the following numeric expression (3):

[ Exp. 3 ]

$$BF = a6 \times BOW + a7 \qquad ...(3)$$

wherein

BF: the pressing force of the bead portions 4 [N]
BOW: a distance between the center 5c in the tire axial direction of the bead core 5 and the outer surface 4a in the tire axial direction of the bead portion 4 [mm]
a6: a coefficient
a7: a constant

Such bead pressing force prediction method can predict the pressing force BF of the bead portion 4 from the distance BOW between the center 5c in the tire axial direction of the bead core 5 and the outer surface 4a in the tire axial direction of the bead portion 4. Therefore, the bead pressing force prediction method of the third embodiment can accurately and easily predict the pressing force BF of the bead portion 4 from the design parameter.

It is desirable that the coefficient a6 and the constant a7 are obtained experimentally by multivariate analysis or the like from values measured using a tire bead pressing force tester in advance.

Here, the coefficient a6 is a coefficient for obtaining the pressing force BF from the distance BOW.

The bead pressing force prediction method of the third embodiment is particularly effectively used for the tire 1 in which the distance BOW is proportional to the thickness Ct inward in the tire radial direction from the bead core 5.

Next, a bead pressing force prediction method of a fourth embodiment will be described. The bead pressing force prediction method of the fourth embodiment comprises a step of predicting the pressing force BF of the bead portion 4 when the tire 1 is fitted onto the rim R of a wheel using the following numeric expression (4):

[ Exp. 4 ]

$$BF = a8 \times BOW + a9 \times \varepsilon c + a10$$
$$\varepsilon c = \left(1 - \frac{(IDw - ODR) \times 0.5}{Ct}\right) \times 100 \qquad ...(4)$$

wherein

BF: the pressing force of the bead portions 4 [N]
BOW: a distance between the center 5c in the tire axial direction of the bead core 5 and the outer surface 4a in the tire axial direction of the bead portion 4 [mm]
$\varepsilon c$: compressive strain on the inside in the tire radial direction of the bead core 5 [%}
IDw: the inner diameter of the bead core 5 [mm]
ODR: the diameter of the rim [mm]
Ct: a thickness inward in the tire radial direction from the bead core 5 [mm]
a8, a9: coefficients
a10: a constant

Such bead pressing force prediction method can predict the pressing force BF of the bead portion 4 from the distance BOW between the center 5c in the tire axial direction of the bead core 5 and the outer surface 4a in the tire axial direction of the bead portion 4, the inner diameter IDw of the bead core 5, the diameter ODR of the rim, and the thickness Ct inward in the tire radial direction from the bead core 5. Therefore, from these design parameters, the bead pressing force prediction method of the fourth embodiment can accurately and easily predict the pressing force BF of the bead portion 4.

It is desirable that the coefficient a8, the coefficient a9, and the constant a10 are obtained experimentally by multivariate analysis or the like from values measured using a tire bead pressing force tester in advance.

Here, the coefficient a8 is a coefficient for obtaining the pressing force BF from the distance BOW.

The coefficient a9 is a coefficient for obtaining the pressing force BF from the compressive strain $\varepsilon c$.

In such bead pressing force prediction method, the pressing force BF can be predicted taking into consideration the influence of the compressive strain $\varepsilon c$ on the pressing force BF in addition to the distance BOW, therefore, the pressing force BF of the bead portion 4 can be predicted with higher accuracy.

The bead pressing force prediction method of the fourth embodiment predicts the pressing force BF using the allowable maximum and minimum values of the diameter ODR of the rim, like in the bead pressing force prediction method described above. Such bead pressing force prediction method can always achieve both workability of mounting to the rim R and suppression of rim slippage, bead unseating, air leakage, etc. within the allowable range of the diameter ODR of the rim.

Next, a bead pressing force prediction method of a fifth embodiment will be described.

The bead portion 4 of the fifth embodiment is equipped with a bead core 5 made up of bead wires 8.

The bead pressing force prediction method of the fifth embodiment comprises a step of predicting the pressing force BF of the bead portion 4 when the tire 1 is fitted onto the rim R of a wheel using the following numeric expression (5):

[ Exp. 5 ]

$$BF = a11 \times BOW + a12 \times \varepsilon c + a13 \times BWST + a14$$

$$\varepsilon c = \left(1 - \frac{(IDw - ODR) \times 0.5}{Ct}\right) \times 100 \qquad \qquad ...(5)$$

$$BWST = BWd \times BWdn$$

wherein

BF: the pressing force of the bead portions 4 [N]
BOW: a distance between the center 5c in the tire axial direction of the bead core 5 and the outer surface 4a in the tire axial direction of the bead portion 4 [mm]
$\varepsilon c$: compressive strain on the inside in the tire radial direction of the bead core 5 [%}
BWST: a width of the bead core 5 at the innermost position in the radial direction of the tire [mm]
IDw: the inner diameter of the bead core 5 [mm]
ODR: the diameter of the rim [mm]
Ct: a thickness inward in the tire radial direction from the bead core 5 [mm]
BWd: a wire diameter of the bead wire [mm]
BWdn: a number of the bead wire(s) 8 arranged on the most inside in the tire radial direction [integer]
a11, a12, a13: coefficients
a14: a constant

Such bead pressing force prediction method can predict the pressing force BF of the bead portion 4 from the distance BOW between the center 5c in the tire axial direction of the bead core 5 and the outer surface 4a in the tire axial direction of the bead portion 4, the inner diameter IDw of the bead core 5, the diameter ODR of the rim, the thickness Ct inward in the tire radial direction from the bead core 5, the wire diameter BWd of the bead wires, and the number BWdn of the bead wire(s) 8 arranged on the most inside in the tire radial direction. Therefore, from these design parameters, the bead pressing force prediction method of the fifth embodiment can accurately and easily predict the pressing force BF of the bead portion 4.

It is desirable that the coefficient all, the coefficient a12, the coefficient a13, and the constant a14 are experimentally determined by multivariate analysis or the like from values measured using a tire bead pressing force tester in advance.

The coefficient all is a coefficient for obtaining the pressing force BF from the distance BOW.

The coefficient a12 is a coefficient for obtaining the pressing force BF from the compressive strain $\varepsilon c$.

The coefficient a13 is a coefficient for obtaining the pressing force BF from a bead wire configuration BWST based on the width of the bead core 5 at the innermost position in the radial direction of the tire.

The number BWdn of the bead wire(s) 8 arranged on the most inside in the tire radial direction is, for example, three in the examples of FIGS. 2 and 3, and five in the example of FIG. 4.

Such bead pressing force prediction method can determine the pressing force BF by taking into account the effect of the bead wire configuration BWST on the pressing force BF in addition to the distance BOW and the compressive strain $\varepsilon c$. Therefore, the pressing force BF can be predicted more accurately.

In the bead pressing force prediction method of the fifth embodiment predicts the pressing force BF using the allowable maximum and minimum values of the diameter ODR of the rim, like in the bead pressing force prediction method described above. Such bead pressing force prediction method can always achieve both workability of mounting to the rim R and suppression of rim slippage, bead unseating, air leakage, etc. within the allowable range of the diameter ODR of the rim.

In the methods of predicting the bead pressing force using the above numeric expression (3), the above numeric expression (4) and the above numeric expression (5), it is desirable that the distance BOW between the center 5c in the tire axial direction of the bead core 5 and the outer surface 4a in the tire axial direction of the bead portion 4 is predicted by using the following numeric expression (6):

[ Exp. 6 ]

$$BOW = a15 \times \left( BG + tch \times Nch + tc \times Onc + \sum_{j=1}^{n} (tj \times Nj) + \frac{BW\max}{2} + a16 \right) + a17 \quad ...(6)$$

wherein

BOW: the distance between the center 5c in the tire axial direction of the bead core 5 and the outer surface 4a in the tire axial direction of the bead portion 4 [mm]
BG: a thickness of rubber on the outer side in the tire axial direction than the bead core 5 [mm]
tch: a thickness of a chafer rubber 9 [mm]
Nch: a number of the chafer rubber(s) 9 [integer]
tc: a thickness of the carcass ply 6A [mm]
ONc: a number of the carcass ply or plies 6A located axially outside the bead core 5 [integer]
tj: a thickness of other member [mm]
Nj: a number of the other member(s) [integer]
BWmax: the maximum width of the bead core 5 [mm]
a15: a coefficient
a16: a thickness of other rubber [mm]
a17: a constant

Such bead pressing force prediction method can easily and accurately determine the distance BOW between the center 5c in the tire axial direction of the bead core 5 and the outer surface 4a in the tire axial direction of the bead portion 4.
It is desirable that the coefficient a15 and the constant a17 are obtained experimentally by multivariate analysis or the like from values measured using a tire bead pressing force tester in advance.
The coefficient a15 is a coefficient for obtaining the distance BOW from the thickness outward in the tire axial direction from the bead core 5 and the maximum width BWmax of the bead core 5.
If the carcass ply 6A, the chafer rubber 9 and other members located axially outside the bead core 5 do not exist, then 0 is entered as the respective number.
For the thickness a16 of the other rubber, 0 is also entered when there is no other rubber.
In the method of predicting the bead pressing force using the above numeric expression (6), it is desirable to predict the maximum width BWmax of the bead core 5 using the following numeric expression (7):

[ Exp. 7 ]

$$BW\max = a18 \times BWd \times BWdn\max + a19 \quad ...(7)$$

wherein

BWmax: the maximum width of the bead core [mm]
BWd: the wire diameter of the bead wires
BWdnmax: the maximum number of the bead wires arranged in the axial direction of the tire [integer]
a18: a coefficient
a19: a constant

Such bead pressing force prediction method can accurately and easily determine the maximum width BWmax of the bead core 5. It is desirable that the coefficient a18 and the constant a19 are determined experimentally by multivariate analysis or the like from values measured using a tire bead pressing force tester in advance.

The coefficient a18 is a coefficient for obtaining the maximum width BWmax of the bead core 5 from the configuration of the bead wire 8.

In the methods of predicting the bead pressing force using the above numeric expression (1), the above numeric expression (2), the above numeric expression (4), and the above numeric expression (5),
it is desirable that the thickness Ct inward in the tire radial direction from the bead core 5 is predicted by using the following numeric expression (8):

[ Exp. 8 ]

$$Ct = a20 \times \left( ti \times Ni + tc \times UNc + tch \times Nch + \sum_{j=1}^{n} (tj \times Nj) + a21 \right) \quad ... \ (8)$$

wherein

Ti: a thickness of an inner liner [mm]
Ni: a number of the inner liner(s) located inward in the tire radial direction of the bead core 5 [integer]
tc: the thickness of the carcass ply 6A [mm]
UNc: a number of the carcass ply or plies 6A located inward in the tire radial direction of the bead core 5 [integer]
tch: a thickness of the chafer rubber 9 [mm]
Nch: a number of the chafer rubber(s) 9 located inward in the tire radial direction of the bead core 5 [integer]
tj: the thickness of the other member [mm]
Nj: a number of the other member(s) located inward in the tire radial direction of the bead core 5 [integer]
a20: a constant
a21: a thickness of other rubber [mm]

Such bead pressing force prediction method can accurately and easily determine the thickness Ct inward in the tire radial direction from the bead core 5.

It is desirable that the constant a20 is obtained experimentally by multivariate analysis or the like from values measured using a tire bead pressing force tester in advance.

In addition, if the inner liner, carcass ply 6A, chafer rubber 9, and other members located inward in the tire radial direction of the bead core 5 do not exist, 0 is entered as the respective number.

For the thickness a21 of the other rubber, 0 is entered when there is no other rubber.

Next, a method of manufacturing the tire 1 using the bead pressing force prediction method described above will be described.

The method of manufacturing the tire 1 of the present embodiment comprises a step of configuring the bead portion 4 so that the pressing force BF of the bead portion 4 predicted by the bead pressing force prediction method described above falls within a certain range.

The certain range of the pressing force BF of the bead portion 4 is preferably 1000 to 10000 N.

when the predicted pressing force BF is greater than 1000 N, the rim slippage, bead unseating, air leakage, etc. can be suppressed.

From this point of view, the lower limit of the pressing force BF is preferably 1200 N, more preferably 1500 N, and still more preferably 1700 N.

By having the predicted pressing force BF smaller than 10000 N, it is possible to maintain good mounting workability to the rim R.

From this point of view, the upper limit of the pressing force BF is preferably 8000 N, more preferably 7000 N, and still more preferably 6500 N.

Next, the tire 1 using the bead pressing force prediction method described above will be described.

In the tire 1 of this embodiment, the pressing force BF of the bead portion 4 predicted by the bead pressing force prediction method described above is 1000 to 10000 N.

Such tire 1 can achieve both workability of mounting on the rim R and suppression of the rim slippage, bead unseating, air leakage and the like.

while detailed description has been made of the especially preferable embodiments of the present invention, the present invention can be embodied in various modes without being limited to the above-described embodiments.

Examples

Three types of tires having the basic structure shown in Fig. 1 were prototyped, and as examples, the pressing force of the bead portion was calculated using the above numeric expressions (1) to (8).

As a comparative example, the pressing force of the bead portion was calculated using the following numeric expression (9):

[ Exp. 9 ]

$$BF = a22 \times Ct + a23 \qquad \qquad ...(9)$$

wherein

> BF: the pressing force of the bead portions 4 [N]
> Ct: a thickness inward in the tire radial direction from the bead core [mm]
> a22: a coefficient for obtaining the pressing force from the thickness
> a23: a constant

The coefficient a22 and the constant a23 were respectively obtained experimentally from other values measured in advance.

For the prototype tires, a comparison test was conducted between the predicted values, which were the results of these calculations, and the measurement results of the bead pressing force measured using a tire bead pressing force tester.

The result is obtained as the ratio of the predicted value/the measured value x 100 (%), wherein the ratio is closer to 100, the difference from the measured value is smaller and the prediction accuracy is better.

The test results are shown in Table 1.

[Table 1]

| | Comparative example | Example 1 | Example 2 | Example 3 | Example 4 | Example 5 | Example 6 | Example 7 | Example 8 | Example 9 |
|---|---|---|---|---|---|---|---|---|---|---|
| Equation(s) used for prediction | 8+9 | 1 | 3 | 1+8 | 2+8 | 3+6 | 3+6+7 | 4+6+7 | 5+6+7 | 5+6+7+8 |
| Tire A Ratio to measured value (%) | 78.1 | 120.9 | 117.9 | 117.3 | 107.4 | 113.0 | 111.6 | 108.4 | 108.3 | 107.9 |
| Tire B Ratio to measured value (%) | 125.9 | 74.2 | 110.9 | 80.6 | 95.7 | 92.0 | 101.2 | 99.0 | 99.7 | 99.8 |
| Tire C Ratio to measured value (%) | 83.7 | 115.3 | 112.5 | 111.8 | 102.4 | 107.8 | 106.5 | 103.4 | 103.3 | 102.9 |
| Tire D Ratio to measured value (%) | 89.6 | 109.5 | 110.2 | 106.2 | 97.3 | 110.0 | 105.4 | 102.4 | 101.6 | 99.1 |
| Tire E Ratio to measured value (%) | 82.5 | 111.6 | 115.5 | 88.5 | 93.3 | 113.4 | 90.6 | 93.0 | 94.0 | 97.0 |

From the test results, it was confirmed that, for each tire, the predicted bead pressing force of the example was closer to the measured value than the comparative example, and the bead pressing force could be accurately and easily predicted from the design parameters.

[Appendix]

The present disclosure is as follows.

[ Present Disclosure 1 ]

A bead pressing force prediction method, which is a method for predicting a pressing force of a bead portion of a tire equipped with a bead core in the bead portion, and which comprises a step of predicting the pressing force of the bead portion when the tire is fitted onto a rim of a wheel by using the following numeric expression (1):

[ Exp. 1 ]

$$BF = a1 \times \varepsilon c + a2$$
$$\varepsilon c = \left(1 - \frac{(IDw - ODR) \times 0.5)}{Ct}\right) \times 100 \qquad \ldots (1)$$

wherein

BF: the bead pressing force [N]
$\varepsilon c$: compressive strain on the inside in the radial direction of the tire of the bead core 5 [%]
IDw: the inner diameter of the bead core 5 [mm]
ODR: the diameter of the rim [mm]
Ct: a thickness inward in the radial direction of the tire from the bead core 5 [mm]
a1: a coefficient for obtaining the pressing force BF from the compressive strain $\varepsilon c$
a2: a constant

[ Present Disclosure 2 ]

A bead pressing force prediction method, which is a method for predicting a pressing force of a bead portion of a tire equipped with a bead core in the bead portion, the bead core being composed of a bead wire, and which comprises a step of predicting the pressing force of the bead portion when the tire is fitted onto a rim of a wheel by using the following numeric expression (2):

[ Exp. 2 ]

$$BF = a3 \times \varepsilon c + a4 \times BWST + a5$$
$$\varepsilon c = \left(1 - \frac{(IDw - ODR) \times 0.5)}{Ct}\right) \times 100 \qquad \ldots (2)$$
$$BWST = BWd \times BWdn$$

wherein

BF: the bead pressing force [N]
$\varepsilon c$: compressive strain on the inside in the tire radial direction of the bead core 5 [%}
IDw: the inner diameter of the bead core 5 [mm]
ODR: the diameter of the rim [mm]

Ct: a thickness inward in the tire radial direction from the bead core 5 [mm]
BWST: a bead wire configuration
BWd: a wire diameter of the bead wire [mm]
BWdn: a number of the bead wires 8 arranged on the most inside in the tire radial direction [integer]
a3: a coefficient for obtaining the pressing force from the compressive strain
a4: a coefficient for obtaining the pressing force from the bead wire configuration
a5: a constant

[ Present Disclosure 3 ]

A bead pressing force prediction method, which is a method for predicting a pressing force of a bead portion of a tire equipped with a bead core in the bead portion, and which comprises a step of predicting the pressing force of the bead portion when the tire is fitted onto a rim of a wheel by using the following numeric expression (3):

[ Exp. 3 ]

$$BF = a6 \times BOW + a7 \qquad \qquad ...(3)$$

wherein

BF: the pressing force of the bead portions 4 [N]
BOW: a distance between the center 5c in the tire axial direction of the bead core 5 and the outer surface 4a in the tire axial direction of the bead portion 4 [mm]
a6: a coefficient
a7: a constant

[ Present Disclosure 4 ]

A bead pressing force prediction method, which is a method for predicting a pressing force of a bead portion of a tire equipped with a bead core in the bead portion, and which comprises a step of predicting the pressing force of the bead portion when the tire is fitted onto a rim of a wheel by using the following numeric expression (4):

[ Exp. 4 ]

$$BF = a8 \times BOW + a9 \times \varepsilon c + a10$$
$$\varepsilon c = \left(1 - \frac{(IDw - ODR) \times 0.5}{Ct}\right) \times 100 \qquad ...(4)$$

wherein

BF: the pressing force of the bead portions 4 [N]
BOW: a distance between the center 5c in the tire axial direction of the bead core 5 and the outer surface 4a in the tire axial direction of the bead portion 4 [mm]
εc: compressive strain on the inside in the tire radial direction of the bead core 5 [%}
IDw: the inner diameter of the bead core 5 [mm]
ODR: the diameter of the rim [mm]
Ct: a thickness inward in the tire radial direction from the bead core 5 [mm]
a8, a9: coefficients
a10: a constant

[ Present Disclosure 5 ]

A bead pressing force prediction method, which is a method for predicting a pressing force of a bead portion of a tire equipped with a bead core in the bead portion, the bead core being composed of a bead wire, and which comprises a step of predicting the pressing force of the bead portion when the tire is fitted onto a rim of a wheel by using the following numeric expression (5):

[ Exp. 5 ]

$$BF = a11 \times BOW + a12 \times \varepsilon c + a13 \times BWST + a14$$

$$\varepsilon c = \left(1 - \frac{(IDw - ODR) \times 0.5}{Ct}\right) \times 100 \qquad ...(5)$$

$$BWST = BWd \times BWdn$$

wherein

BF: the pressing force of the bead portions 4 [N]
BOW: a distance between the center 5c in the tire axial direction of the bead core 5 and the outer surface 4a in the tire axial direction of the bead portion 4 [mm]
$\varepsilon c$: compressive strain on the inside in the tire radial direction of the bead core 5 [%}
BWST: a width of the bead core 5 at the innermost position in the radial direction of the tire [mm]
IDw: the inner diameter of the bead core 5 [mm]
ODR: the diameter of the rim [mm]
Ct: a thickness inward in the tire radial direction from the bead core 5 [mm]
BWd: a wire diameter of the bead wire [mm]
BWdn: a number of the bead wire(s) 8 arranged on the most inside in the tire radial direction [integer]
all, a12, a13: coefficients
a14: a constant

[ Present Disclosure 6 ]

The bead pressing force prediction method as set forth in Present Disclosure 1, 2, 4, or 5, wherein the pressing force of the bead portion is predicted by using an allowable maximum value and allowable minimum value of the diameter ODR of the rim,

[ Present Disclosure 7 ]

The bead pressing force prediction method as set forth in any one of Present Disclosures 3 to 5, wherein the distance between the center in the tire axial direction of the bead core and the outer surface in the tire axial direction of the bead portion is predicted by using the following numeric expression (6):

[ Exp. 6 ]

$$BOW = a15 \times \left( BG + tch \times Nch + tc \times Onc + \sum_{j=1}^{n}(tj \times Nj) + \frac{BW\max}{2} + a16 \right) + a17 \qquad ...(6)$$

wherein

BOW: the distance between the center 5c in the tire axial direction of the bead core 5 and the outer surface 4a in the tire axial direction of the bead portion 4 [mm]

BG: a thickness of rubber on the outer side in the tire axial direction than the bead core 5 [mm]
tch: a thickness of a chafer rubber 9 [mm]
Nch: a number of the chafer rubber(s) 9 [integer]
tc: a thickness of the carcass ply 6A [mm]
ONc: a number of the carcass ply or plies 6A located axially outside the bead core 5 [integer]
tj: a thickness of other member [mm]
Nj: a number of the other member(s) [integer]
BWmax: the maximum width of the bead core 5 [mm]
a15: a coefficient
a16: a thickness of other rubber [mm]
a17: a constant

[ Present Disclosure 8 ]

The bead pressing force prediction method as set forth in Present Disclosure 7, wherein the maximum width of the bead core is predicted by using the following numeric expression (7):

[ Exp. 7 ]

$$BW\max = a18 \times BWd \times BWdn\max + a19 \qquad ...(7)$$

wherein

BWmax: the maximum width of the bead core [mm]
BWd: the wire diameter of the bead wires
BWdnmax: the maximum number of the bead wires arranged in the axial direction of the tire [integer]
a18: a coefficient
a19: a constant

[ Present Disclosure 9 ]

The bead pressing force prediction method as set forth in Present Disclosure 1, 2, 4, or 5, wherein the thickness inward in the tire radial direction from the bead core is predicted by using the following numeric expression (8):

[Exp. 8]

$$Ct = a20 \times \left( ti \times Ni + tc \times UNc + tch \times Nch + \sum_{j=1}^{n} (tj \times Nj) + a21 \right) \quad ... (8)$$

wherein

Ti: a thickness of an inner liner [mm]
Ni: a number of the inner liner(s) located inward in the tire radial direction of the bead core 5 [integer]
tc: the thickness of the carcass ply 6A [mm]
UNc: a number of the carcass ply or plies 6A located inward in the tire radial direction of the bead core 5 [integer]
tch: a thickness of the chafer rubber 9 [mm]
Nch: a number of the chafer rubber(s) 9 located inward in the tire radial direction of the bead core 5 [integer]
tj: the thickness of the other member [mm]
Nj: a number of the other member(s) located inward in the tire radial direction of the bead core 5 [integer]
a20: a constant

a21: a thickness of other rubber [mm]

[ Present Disclosure 10 ]

A tire manufacturing method which is a method of manufacturing a tire comprising a step of configuring a bead portion so that a pressing force of the bead portion predicted by the bead pressing force prediction method as set forth in any one of Present Disclosure 1 to 9 becomes 1000 to 10000 N.

[ Present Disclosure 11 ]

A tire, which is a tire of which pressing force of a bead portion predicted by the bead pressing force prediction method as set forth in any one of Present Disclosures 1 to 9, is 1000 to 10000 N.

Explanation of References

1    tire
4    bead portion
4a   surface
5    bead core
5c   center

**Claims**

1.  A bead pressing force prediction method, which is a method for predicting a pressing force of a bead portion of a tire equipped with a bead core in the bead portion, and which comprises a step of predicting the pressing force of the bead portion when the tire is fitted onto a rim of a wheel by using the following numeric expression (1):
    [ Exp. 1 ]

$$BF = a1 \times \varepsilon c + a2$$
$$\varepsilon c = \left(1 - \frac{(IDw - ODR) \times 0.5)}{Ct}\right) \times 100 \qquad \ldots(1)$$

wherein

BF: the bead pressing force [N]
$\varepsilon c$: compressive strain on the inside in the radial direction of the tire of the bead core 5 [%]
IDw: the inner diameter of the bead core 5 [mm]
ODR: the diameter of the rim [mm]
Ct: a thickness inward in the radial direction of the tire from the bead core 5 [mm]
a1: a coefficient for obtaining the pressing force BF from the compressive strain $\varepsilon c$
a2: a constant

2.  A bead pressing force prediction method, which is a method for predicting a pressing force of a bead portion of a tire equipped with a bead core in the bead portion, the bead core being composed of a bead wire, and which comprises a step of predicting the pressing force of the bead portion when the tire is fitted onto a rim of a wheel by using the following numeric expression (2):
    [ Exp. 2 ]

$$BF = a3 \times \varepsilon c + a4 \times BWST + a5$$

$$\varepsilon c = \left(1 - \frac{(IDw - ODR) \times 0.5}{Ct}\right) \times 100 \qquad ...(2)$$

$$BWST = BWd \times BWdn$$

wherein

BF: the bead pressing force [N]
$\varepsilon c$: compressive strain on the inside in the tire radial direction of the bead core 5 [%}
IDw: the inner diameter of the bead core 5 [mm]
ODR: the diameter of the rim [mm]
Ct: a thickness inward in the tire radial direction from the bead core 5 [mm]
BWST: a bead wire configuration
BWd: a wire diameter of the bead wire [mm]
BWdn: a number of the bead wires 8 arranged on the most inside in the tire radial direction [integer]
a3: a coefficient for obtaining the pressing force from the compressive strain
a4: a coefficient for obtaining the pressing force from the bead wire configuration
a5: a constant

3. A bead pressing force prediction method, which is a method for predicting a pressing force of a bead portion of a tire equipped with a bead core in the bead portion, and which comprises a step of predicting the pressing force of the bead portion when the tire is fitted onto a rim of a wheel by using the following numeric expression (3):
[ Exp. 3 ]

$$BF = a6 \times BOW + a7 \qquad ...(3)$$

wherein

BF: the pressing force of the bead portions 4 [N]
BOW: a distance between the center 5c in the tire axial direction of the bead core 5 and the outer surface 4a in the tire axial direction of the bead portion 4 [mm]
a6: a coefficient
a7: a constant

4. A bead pressing force prediction method, which is a method for predicting a pressing force of a bead portion of a tire equipped with a bead core in the bead portion, and which comprises a step of predicting the pressing force of the bead portion when the tire is fitted onto a rim of a wheel by using the following numeric expression (4):
[ Exp. 4 ]

$$BF = a8 \times BOW + a9 \times \varepsilon c + a10$$

$$\varepsilon c = \left(1 - \frac{(IDw - ODR) \times 0.5}{Ct}\right) \times 100 \qquad ...(4)$$

wherein

BF: the pressing force of the bead portions 4 [N]
BOW: a distance between the center 5c in the tire axial direction of the bead core 5 and the outer surface 4a in the tire axial direction of the bead portion 4 [mm]
$\varepsilon c$: compressive strain on the inside in the tire radial direction of the bead core 5 [%}
IDw: the inner diameter of the bead core 5 [mm]
ODR: the diameter of the rim [mm]
Ct: a thickness inward in the tire radial direction from the bead core 5 [mm]
a8, a9: coefficients

a10: a constant

5. A bead pressing force prediction method, which is a method for predicting a pressing force of a bead portion of a tire equipped with a bead core in the bead portion, the bead core being composed of a bead wire, and which comprises a step of predicting the pressing force of the bead portion when the tire is fitted onto a rim of a wheel by using the following numeric expression (5):
[ Exp. 5 ]

$$BF = a11 \times BOW + a12 \times \varepsilon c + a13 \times BWST + a14$$

$$\varepsilon c = \left(1 - \frac{(IDw - ODR) \times 0.5}{Ct}\right) \times 100 \qquad ...(5)$$

$$BWST = BWd \times BWdn$$

wherein

BF: the pressing force of the bead portions 4 [N]
BOW: a distance between the center 5c in the tire axial direction of the bead core 5 and the outer surface 4a in the tire axial direction of the bead portion 4 [mm]
$\varepsilon c$: compressive strain on the inside in the tire radial direction of the bead core 5 [%}
BWST: a width of the bead core 5 at the innermost position in the radial direction of the tire [mm]
IDw: the inner diameter of the bead core 5 [mm]
ODR: the diameter of the rim [mm]
Ct: a thickness inward in the tire radial direction from the bead core 5 [mm]
BWd: a wire diameter of the bead wire [mm]
BWdn: a number of the bead wire(s) 8 arranged on the most inside in the tire radial direction [integer]
all, a12, a13: coefficients
a14: a constant

6. The bead pressing force prediction method as set forth in claim 1, 2, 4, or 5, wherein
the pressing force of the bead portion is predicted by using an allowable maximum value and allowable minimum value of the diameter of the rim.

7. The bead pressing force prediction method as set forth in any one of claims 3 to 5, wherein
the distance between the center in the tire axial direction of the bead core and the outer surface in the tire axial direction of the bead portion is predicted by using the following numeric expression (6):
[ Exp. 6 ]

$$BOW = a15 \times \left(BG + tch \times Nch + tc \times Onc + \sum_{j=1}^{n}(tj \times Nj) + \frac{BW\max}{2} + a16\right) + a17 \qquad ...(6)$$

wherein

BOW: the distance between the center 5c in the tire axial direction of the bead core 5 and the outer surface 4a in the tire axial direction of the bead portion 4 [mm]
BG: a thickness of rubber on the outer side in the tire axial direction than the bead core 5 [mm]
tch: a thickness of a chafer rubber 9 [mm]
Nch: a number of the chafer rubber(s) 9 [integer]
tc: a thickness of the carcass ply 6A [mm]
ONc: a number of the carcass ply or plies 6A located axially outside the bead core 5 [integer]
tj: a thickness of other member [mm]
Nj: a number of the other member(s) [integer]
BWmax: the maximum width of the bead core 5 [mm]
a15: a coefficient
a16: a thickness of other rubber [mm]

a17: a constant

8. The bead pressing force prediction method as set forth in claim 7, wherein
the maximum width of the bead core is predicted by using the following numeric expression (7):
[ Exp. 7 ]

$$BW\max = a18 \times BWd \times BWdn\max + a19 \qquad ...(7)$$

wherein

BWmax: the maximum width of the bead core [mm]
BWd: the wire diameter of the bead wires
BWdnmax: the maximum number of the bead wires arranged in the axial direction of the tire [integer]
a18: a coefficient
a19: a constant

9. The bead pressing force prediction method as set forth in claim 1, 2, 4, or 5, wherein
the thickness inward in the tire radial direction from the bead core is predicted by using the following numeric expression (8):
[ Exp. 8 ]

$$Ct = a20 \times \left( ti \times Ni + tc \times UNc + tch \times Nch + \sum_{j=1}^{n} (tj \times Nj) + a21 \right) \quad ... (8)$$

wherein

Ti: a thickness of an inner liner [mm]
Ni: a number of the inner liner(s) located inward in the tire radial direction of the bead core 5 [integer]
tc: the thickness of the carcass ply 6A [mm]
UNc: a number of the carcass ply or plies 6A located inward in the tire radial direction of the bead core 5 [integer]
tch: a thickness of the chafer rubber 9 [mm]
Nch: a number of the chafer rubber(s) 9 located inward in the tire radial direction of the bead core 5 [integer]
tj: the thickness of the other member [mm]
Nj: a number of the other member(s) located inward in the tire radial direction of the bead core 5 [integer]
a20: a constant
a21: a thickness of other rubber [mm]

10. A tire manufacturing method which is a method of manufacturing a tire comprising a step of configuring a bead portion so that a pressing force of the bead portion predicted by the bead pressing force prediction method as set forth in any one of claims 1 to 9 becomes 1000 to 10000 N.

11. A tire, which is a tire of which pressing force of a bead portion predicted by the bead pressing force prediction method as set forth in any one of claims 1 to 9, is 1000 to 10000 N.

FIG.1

# FIG.2

EP 4 275 918 A1

# FIG.3

EP 4 275 918 A1

# FIG.4

EP 4 275 918 A1

<table>
<tr><td colspan="2">**INTERNATIONAL SEARCH REPORT**</td><td>International application No.<br><br>**PCT/JP2021/038056**</td></tr>
</table>

**A. CLASSIFICATION OF SUBJECT MATTER**

***B60C 19/00***(2006.01)i; ***B60C 15/02***(2006.01)i
FI:  B60C19/00 Z; B60C15/02 Z

According to International Patent Classification (IPC) or to both national classification and IPC

**B. FIELDS SEARCHED**

Minimum documentation searched (classification system followed by classification symbols)

B60C1/00-19/12; B60C99/00; B29D30/00-30/72; G02M17/02; G06F30/00-30/337

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 63-149207 A (YOKOHAMA RUBBER CO LTD) 22 June 1988 (1988-06-22)<br>    claims, p. 2, upper left column, line 10 to p. 4, upper left column, line 16, fig. 1-5 | 11 |
| X | JP 9-109624 A (SUMITOMO RUBBER IND LTD) 28 April 1997 (1997-04-28)<br>    claims, paragraphs [0018]-[0028], fig. 1-5 | 11 |
| E, X | JP 2021-167144 A (SUMITOMO RUBBER IND LTD) 21 October 2021 (2021-10-21)<br>    claims, paragraphs [0001]-[0042], fig. 1-2 | 1, 2, 6, 9-11 |
| A | JP 7-215024 A (COMPANGIE GENERALE DES ETABLISSEMENTS MICHELIN -<br>MICHELIN & CIE) 15 August 1995 (1995-08-15)<br>    entire text | 1-11 |
| A | CN 106599413 A (ANHUI GITI RADIAL TIRE CO., LTD.) 26 April 2017 (2017-04-26)<br>    entire text | 1-11 |
| A | CN 106739843 A (ANHUI GITI RADIAL TIRE CO., LTD.) 31 May 2017 (2017-05-31)<br>    entire text | 1-11 |

☑ Further documents are listed in the continuation of Box C.     ☑ See patent family annex.

| | |
|---|---|
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **09 November 2021** | **22 November 2021** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

| International application No. |
| --- |
| **PCT/JP2021/038056** |

**C.      DOCUMENTS CONSIDERED TO BE RELEVANT**

| Category* | Citation of document, with indication, where appropriate, of the relevant passages | Relevant to claim No. |
| --- | --- | --- |
| A | JP 2020-59432 A (YOKOHAMA RUBBER CO LTD) 16 April 2020 (2020-04-16) entire text | 1-11 |
| A | JP 9-58227 A (YOKOHAMA RUBBER CO LTD) 04 March 1997 (1997-03-04) entire text | 1-11 |
| A | JP 10-147115 A (SUMITOMO RUBBER IND LTD) 02 June 1998 (1998-06-02) entire text | 1-11 |
| A | JP 59-124415 A (YOKOHAMA RUBBER CO LTD) 18 July 1984 (1984-07-18) entire text | 1-11 |

Form PCT/ISA/210 (second sheet) (January 2015)

INTERNATIONAL SEARCH REPORT
Information on patent family members

International application No.

**PCT/JP2021/038056**

| Patent document cited in search report | | | Publication date (day/month/year) | Patent family member(s) | | | Publication date (day/month/year) |
|---|---|---|---|---|---|---|---|
| JP | 63-149207 | A | 22 June 1988 | (Family: none) | | | |
| JP | 9-109624 | A | 28 April 1997 | (Family: none) | | | |
| JP | 2021-167144 | A | 21 October 2021 | (Family: none) | | | |
| JP | 7-215024 | A | 15 August 1995 | FR | 2714179 | A1 | |
| CN | 106599413 | A | 26 April 2017 | (Family: none) | | | |
| CN | 106739843 | A | 31 May 2017 | (Family: none) | | | |
| JP | 2020-59432 | A | 16 April 2020 | WO | 2020/075346 | A1 | |
| JP | 9-58227 | A | 04 March 1997 | (Family: none) | | | |
| JP | 10-147115 | A | 02 June 1998 | US | 5885388 | A | |
| | | | | EP | 798139 | A2 | |
| JP | 59-124415 | A | 18 July 1984 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017193194 A